# DEMANDE DE BREVET EUROPEEN

(11) **EP 3 926 306 A1**
(43) Date de publication de la demande: **22.12.2021**
(21) Numéro de dépôt: 21179542.2
(22) Date de dépôt: 15.06.2021
(51) Int. Cl.: G01D 21/00, H01L 35/30, G01K 1/14, G01M 15/02, B60L 3/12, G01H 1/04

(54) **DISPOSITIF AUTONOME DE SURVEILLANCE D'UN MOTEUR ÉLECTRIQUE D'UN VÉHICULE FERROVIAIRE ET MOTEUR ASSOCIÉ**

(30) Priorité: 15.06.2020 FR 2006201
(71) Demandeur: ALSTOM Transport Technologies, 93400 Saint-Ouen (FR)
(72) Inventeur: GUIGNIER, Gilles, 90000 BELFORT (FR)
(74) Mandataire: Lavoix

(57) **Abrégé**

Dispositif autonome de surveillance (10) d'une machine électrique d'un véhicule, notamment d'un moteur (1) d'un véhicule ferroviaire, du type comportant au moins un capteur (12) de mesure d'une grandeur relative à la machine électrique, un système électronique (14) propre à acquérir les mesures délivrées par le capteur (12), et une batterie (16) d'alimentation électrique du système électronique (14), caractérisé en ce que le dispositif de surveillance (10) comporte, en outre, un module thermoélectrique (30) couplé thermiquement d'une part à une source chaude et d'autre part à une source froide, de manière à générer une puissance électrique de recharge de la batterie (16), la source chaude étant constituée par une carcasse (4) de la machine électrique (1).

## Description

La présente invention concerne un dispositif de surveillance d'un moteur d'un véhicule ferroviaire, du type comportant au moins un capteur de mesure d'une grandeur relative audit moteur, un système électronique propre à acquérir les mesures délivrées par le capteur, et une batterie d'alimentation électrique du système électronique.

L'énergie électrique stockée dans une batterie ne confère qu'une autonomie restreinte au dispositif de surveillance, de l'ordre de quelques heures. Ceci n'est pas compatible avec l'application envisagée, à savoir la surveillance d'un moteur de traction sur plusieurs dizaines d'heures de fonctionnement.

C'est la raison pour laquelle la batterie du dispositif doit être régulièrement rechargée.

Pour ce faire, selon l'état de l'art, le dispositif de surveillance est connecté par un câble d'alimentation basse tension à une source de puissance électrique à bord du véhicule ferroviaire.

Cependant, le dispositif de surveillance doit être implanté à proximité immédiate du moteur à surveiller, par exemple sur le boggie qui supporte ce moteur, afin de limiter la longueur des connexions entre le système électronique et le ou les capteurs disposés sur le moteur.

Or, il s'avère difficile de tirer un câble d'alimentation basse tension entre une source de puissance électrique à bord du véhicule ferroviaire et le boggie. D'autant que, chaque moteur de traction du véhicule ferroviaire devant être surveillé par autant de dispositifs de surveillance, il est nécessaire de multiplier ce type de câblage.

Le but de la présente invention est de résoudre ce problème.

Pour cela, l'invention a pour objet un dispositif autonome de surveillance d'une machine électrique d'un véhicule, notamment d'un moteur d'un véhicule ferroviaire, du type comportant au moins un capteur de mesure d'une grandeur relative à la machine électrique, un système électronique propre à acquérir les mesures délivrées par le capteur, et une batterie d'alimentation électrique du système électronique, ledit dispositif comportant, en outre, un module thermoélectrique couplé thermiquement d'une part à une source chaude et d'autre part à une source froide, de manière à générer une puissance électrique de recharge de la batterie, la source chaude étant constituée par une carcasse de la machine électrique.

Suivant des modes particuliers de réalisation, le dispositif de surveillance comporte une ou plusieurs des caractéristiques suivantes, prises isolément ou suivant toutes les combinaisons techniquement possibles :
- le dispositif comportant un boitier destiné à recevoir le système électronique, la batterie et le module thermoélectrique, le boîtier comportant un fond monté directement sur la carcasse de la machine électrique de manière à être en continuité thermique avec la carcasse, le fond du boiter constituant un moyen de couplage thermique entre le module thermoélectrique et la carcasse de la machine électrique ;
- le fond du boîtier présente une saillie sur laquelle est montée une face chaude du module thermoélectrique ;
- le boîtier porte un dissipateur thermique constituant un moyen de couplage thermique entre le module thermoélectrique et la source froide ;
- la source froide étant constituée par l'air extérieur à la machine électrique, le dissipateur thermique comporte une pluralité d'ailettes de refroidissement disposées à l'extérieur du boitier ;
- le dissipateur thermique présente une saillie sur laquelle est montée une face froide du module thermoélectrique ;
- le dissipateur thermique est monté sur le couvercle du boitier par l'intermédiaire de moyens de fixation élastiques ;
- le dispositif comporte un régulateur de tension connecté entre le module thermoélectrique et la batterie pour adapter la puissance électrique délivrée par le module thermoélectrique en une puissance adaptée à la recharge de la batterie.

L'invention a également pour objet une machine électrique pour véhicule, notamment un moteur pour véhicule ferroviaire, portant un dispositif autonome de surveillance conforme au dispositif précédent.

De préférence, la machine électrique est un moteur électrique de traction.

L'invention et ses avantages seront mieux compris à la lecture de la description détaillée qui va suivre d'un mode de réalisation particulier, donné uniquement à titre d'exemple non limitatif, cette description étant faite en se référant à la figure annexée, qui représente de manière schématique un dispositif de surveillance selon l'invention.

La figure représente de manière schématique, un dispositif de surveillance 10 monté sur un moteur 1. Le moteur 1 est un moteur de traction d'un véhicule ferroviaire, de préférence un moteur électrique, par exemple à aimants permanents.

Le véhicule ferroviaire peut être un train, un métro, un tramway ou l'équivalent.

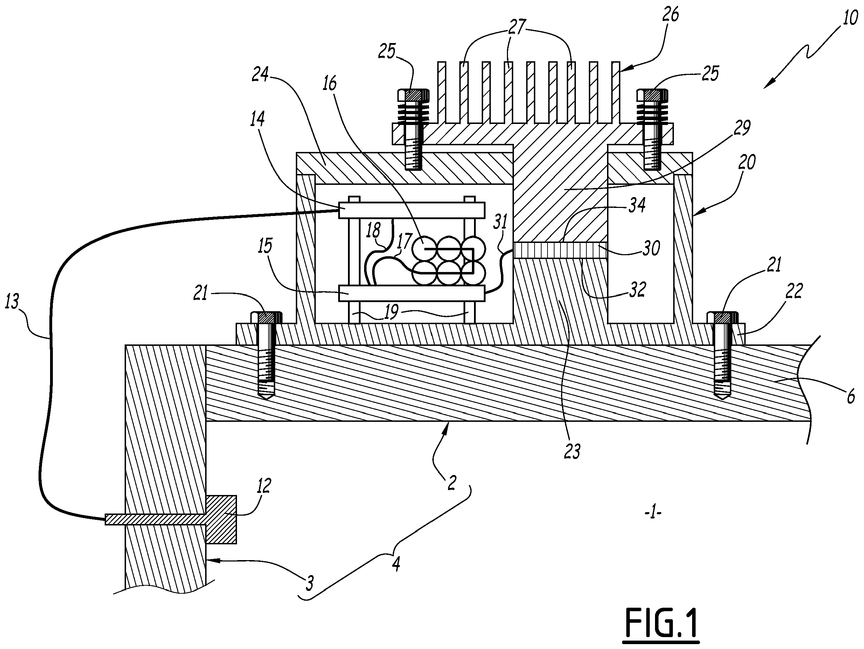

Le moteur 1 comporte une carcasse 4, qui est constituée d'une paroi axiale 2, typiquement cylindrique, dont les extrémités sont obturées par des parois transversales, aussi dénommées flasques. Sur la figure 1, seule une flasque 3 est représentée.

Le dispositif de surveillance 10 comporte un boîtier 20, renfermant un système électronique 14 connecté par une connexion 13 à un capteur 12.

Par exemple, le capteur 12 est un capteur de mesure de la température de l'air à l'intérieur du moteur 1. Il est par exemple monté sur la flasque 3. En variante, le système électronique 14 est connecté à une pluralité de capteurs effectuant des mesures de grandeurs de nature différentes : températures, vibrations, etc. Ces grandeurs physiques permettent d'évaluer l'état de fonctionnement et/ou d'usure du moteur.

Le système électronique 14 est par exemple un circuit électronique imprimé sur une carte PCB, qui est supportée par des colonnes 19 disposées sur le fond du boîtier 20.

Pour l'alimentation électronique du système électronique 14, le dispositif 10 comporte un régulateur de tension 15 et une batterie 16.

La batterie 16 est connectée électriquement par une liaison 17 au régulateur de tension 15, qui est lui-même connecté par une ligne 18 au système électronique 14.

Le boîtier 20 comporte un fond 22, qui est monté directement sur la surface externe 6 de la paroi axiale 2 du moteur 1, au moyen d'un dispositif de fixation, par exemple du type vis 21.

Le boîtier 20 comporte un couvercle 24 permettant d'obturer le boîtier 20 de manière à protéger les équipements qu'il renferme.

Pour la recharge de la batterie 16, est mis en œuvre un module thermoélectrique 30, qui fonctionne de manière à générer une puissance électrique à partir d'un flux de chaleur traversant le module thermoélectrique. Il s'agit de préférence d'au moins une cellule du type cellule Peltier. En variante, plusieurs modules thermoélectriques sont mis en œuvre. Ils sont câblés, soit en série, soit en parallèle, entre une paire de bornes de sortie. De la sorte, la puissance électrique disponible entre les bornes de sortie est plus importante, ce qui permet de répondre aux besoins d'alimentation dans certaines applications.

Le module thermoélectrique 30 est connecté électriquement, par un lien 31 au régulateur de tension 15. Ce dernier permet d'adapter la puissance électrique fournie par le module thermoélectrique 30 en une puissance adaptée pour recharger la batterie 16.

Le module thermoélectrique 30 présente une face inférieure 32, ou face chaude, et une face supérieure 34, ou face froide. La face inférieure 32, orientée vers le moteur 1, est couplée à une source chaude, tandis que la surface supérieure 34, orientée à l'écart du moteur 1, est couplée à une source froide.

Selon l'invention, la source chaude est constituée par la carcasse 4 du moteur 1 qui, lorsque le moteur fonctionne, est rapidement portée à des températures généralement entre 60 et 120°C, typiquement 100°C.

Dans le mode de réalisation représenté sur la figure 1, la source froide est constituée par l'air circulant autour du moteur 1. Il s'agit de l'air atmosphérique à une température généralement entre 0 et 30°C, typiquement 15°C.

Le moyen de couplage thermique entre le module thermoélectrique 30 et la source chaude est constitué par le fond 22 du boîtier 20. En conséquence, la surface du fond 22 qui vient directement en contact de la surface externe 6 de la carcasse 4 est conformée de manière à établir un contact étroit de nature à établir une continuité thermique favorisant les échanges thermiques.

Avantageusement, le fond 22 du boîtier 20 comporte intérieurement une saillie 23 radiale (par rapport à l'axe du moteur 1) sur laquelle est placé le module 30, par exemple au moyen d'une colle adaptée, permettant notamment d'améliorer la conduction thermique entre les pièces qu'elle associe.

Le moyen de couplage entre le module thermoélectrique 30 et la source froide est constitué par un dissipateur thermique 26, fixé sur le couvercle 24 du boitier 20 au moyen d'un système de fixation 25 adapté.

Le dissipateur thermique 26 est conformé de manière à traverser le couvercle 24 pour présenter à l'extérieur du boîtier 20, une structure de dissipation et, à l'intérieur du boîtier 20, une saillie 29 propre à être mise en contact de la surface supérieure 34 du module thermoélectrique 30.

La saillie 29 et la structure de dissipation sont en continuité thermique.

La structure de dissipation est par exemple constituée d'une pluralité d'ailettes 27,

Les ailettes 27 permettent la circulation de l'air ambiant sur une surface d'échange étendue et par conséquent un échange de chaleur entre le dissipateur et l'air extérieur.

Les moyens de fixation 25 sont avantageusement constitués de vis et de ressorts de manière à fournir une certaine élasticité permettant d'absorber les variations dimensionnelles dues aux dilatations thermiques au cours de l'utilisation du moteur. Sans la mise en œuvre de tels moyens de fixation, les variations dimensionnelles risqueraient d'endommager le module thermoélectrique 30.

Ainsi, un flux de chaleur entre la source chaude et la source froide est canalisé pour passer à travers le module thermoélectrique 30.

Ce flux de chaleur est converti par le module thermoélectrique 30 en une puissance électrique qui est appliquée au régulateur de tension 15. Ce dernier adapte la puissance reçue en fonction des caractéristiques tension/courant permettant une recharge efficace de la batterie 16.

L'homme du métier constatera qu'en équipant le dispositif de surveillance selon l'invention d'un module thermoélectrique, il est possible de recharger régulièrement la batterie et, par conséquent, de conférer au dispositif de surveillance une autonomie élevée.

L'avantage de l'utilisation d'un module thermoélectrique est sa résistance aux vibrations. Par conséquent, le dispositif de surveillance n'utilise pas de pièces mobiles. Ceci permet une implantation du dispositif de surveillance directement sur le moteur à surveiller. Ceci permet également d'améliorer la fiabilité du dispositif de surveillance.

Avantageusement, le système électronique 14 est muni de moyens de transmission des mesures acquises du type sans fil, par exemple du type RFID ou Wi-Fi.

Le dispositif de surveillance pourrait être couplé mécaniquement et thermiquement avec d'autres parties d'un moteur, notamment les flasques d'extrémités.

Le dispositif de surveillance selon l'invention est compact. Il occupe par conséquent un volume réduit à la surface du moteur électrique. Ceci constitue un avantage car l'espace disponible sur le boggie est compté, c'est-à-dire l'enveloppe allouée au moteur et à ses accessoires.

Si le cas d'un moteur électrique de traction a plus particulièrement été présenté, l'invention s'applique à tout type de moteur et plus largement à tout type de machine électrique (par exemple un alternateur).

En variante, la source froide pourrait être constituée par un autre fluide que l'air extérieur au moteur, par exemple un liquide caloporteur. La structure de dissipation serait alors constituée d'une tubulure adaptée.

## Revendications

1. Dispositif autonome de surveillance (10) d'une machine électrique d'un véhicule, notamment d'un moteur (1) d'un véhicule ferroviaire, du type comportant au moins un capteur (12) de mesure d'une grandeur relative à la machine électrique, un système électronique (14) propre à acquérir les mesures délivrées par le capteur (12), et une batterie (16) d'alimentation électrique du système électronique (14), **caractérisé en ce que** le dispositif autonome de surveillance (10) comporte, en outre, un module thermoélectrique (30) couplé thermiquement d'une part à une source chaude et d'autre part à une source froide, de manière à générer une puissance électrique de recharge de la batterie (16), la source chaude étant constituée par une carcasse (4) de la machine électrique (1), le dispositif autonome de surveillance (10) comportant un boitier (20) destiné à recevoir le système électronique (14), la batterie (16) et le module thermoélectrique (30), le boîtier (20) comportant un fond (22) monté directement sur la carcasse (4) de la machine électrique (1) de manière à être en continuité thermique avec la carcasse (4), le fond du boiter constituant un moyen de couplage thermique entre le module thermoélectrique (30) et la carcasse (4) de la machine électrique (1).

2. Dispositif autonome de surveillance (10) selon la revendication 1, dans lequel le fond (22) du boîtier (20) présente une saillie sur laquelle est montée une face chaude du module thermoélectrique (30).

3. Dispositif autonome de surveillance (10) selon la revendication 1 ou la revendication 2, dans lequel le boîtier (20) porte un dissipateur thermique (26) constituant un moyen de couplage thermique entre le module thermoélectrique (30) et la source froide.

4. Dispositif autonome de surveillance (10) selon la revendication 3, dans lequel, la source froide étant constituée par l'air extérieur à la machine électrique (1), le dissipateur thermique (26) comporte une pluralité d'ailettes de refroidissement (27) disposées à l'extérieur du boitier (20).

5. Dispositif autonome de surveillance (10) selon la revendication 3 ou la revendication 4, dans lequel le dissipateur thermique (26) présente une saillie sur laquelle est montée une face froide du module thermoélectrique (26).

6. Dispositif autonome de surveillance (10) selon l'une quelconque des revendications 3 à 5, dans lequel le dissipateur thermique (26) est monté sur le couvercle (24) du boitier (20) par l'intermédiaire de moyens de fixation élastiques (25).

7. Dispositif autonome de surveillance (10) selon l'une quelconque des revendications précédentes, comportant un régulateur de tension (15) connecté entre le module thermoélectrique (30) et la batterie (16) pour adapter la puissance électrique délivrée par le module thermoélectrique (30) en une puissance adaptée à la recharge de la batterie (16).

8. Machine électrique pour véhicule, notamment moteur (1) pour véhicule ferroviaire, portant un dispositif autonome de surveillance (10) selon l'une quelconque des revendications 1 à 7.

9. Machine électrique (1) selon la revendication 8, la machine électrique étant un moteur électrique de traction.
